# EUROPÄISCHE PATENTANMELDUNG

(11) **EP 0 810 724 A2**
(43) Veröffentlichungstag der Anmeldung: **03.12.1997**
(21) Anmeldenummer: 97107394.5
(22) Anmeldetag: 05.05.1997
(51) Int. Cl.: H03H 9/02

(54) **Mit akustischen Oberflächenwellen arbeitendes akustoelektronisches Bauelement**

(30) Priorität: 31.05.1996 DE 19622013
(71) Anmelder: SIEMENS AKTIENGESELLSCHAFT, 80333 München (DE)
(72) Erfinder: Wixforth, Achim, Dr., 80636 München (DE)

(57) **Zusammenfassung**

Mit akustischen Oberflächenwellen arbeitendes akustoelektronisches Bauelement, bei dem eine in einem piezoelektrischen Substrat (1) geführte akustische Oberflächenwelle mit einem Elektronensystem (4, 5, 6) in Wechselwirkung tritt, das auf dem Substrat (1) in der Laufstrecke der akustischen Oberflächenwelle angeordnet und als in seiner elektrischen Leitfähigkeit durch Feldeffekt abstimmbarer Elektronenkanal ausgebildet ist.

## Beschreibung

Die vorliegende Erfindung betrifft ein mit akustischen Oberflachenwellen arbeitendes akusto-elektronisches Bauelement nach dem Oberbegriff des Patentanspruchs 1.

Aus Physical Review B, Vol. 40, No. 11, 15.10.1989, 7874-7887 sind grundsätzliche Prinzipien von Wechselwirkungseffekten zwischen akustischen Oberflächenwellen und Halbleiterelektronensystemen bekannt. Insbesondere werden in dieser Druckschrift akustische Oberflächenwellen auf GaAs/AlₓGa₁₋ₓAs-Heterostrukturen diskutiert. Speziell wird dabei die Wechselwirkung zwischen akustischen Oberflächenwellen und quasizweidimensionalen Inversionselektronensystemen in starken magnetischen Feldern und bei tiefen Temperaturen untersucht. Dabei wird darauf hingewiesen, daß die Wechselwirkung zwischen akustischen Oberflächenwellen und hochbeweglichen quasi-zweidimensionalen Elektronen auf einem Relaxationsmechanismus führt. Diese Wechselwirkung wird über starke Quantenoszillationen sowohl der Oberflächenwellenintensität als auch in der Schallgeschwindigkeit nachgewiesen, die Quantenoszillationen der Magneto- Leitfähigkeit des quasizweidimensionalen Elektronensystems in starken Magnetfeldern widerspiegeln.

Beispielsweise aus IEEE Transactions on Microwave Theory and Techniques, Vol. MTT-29, No. 12, 12.12.1981, 1348-1356 oder IEEE Transactions on Sonics and Ultrasonics, Vol. SU-29, Nr. 5, Sept. 1982, 255-261 sind mit integrierter Schaltkreistechnik kompatible Oberflächenwellenanordnungen auf GaAs bzw. Si bekannt. Es wird dabei auf die Möglichkeit der Realisierung von abstimmbaren OFW-Resonatoren, abstimmbaren GaAs-OFW-Oszillatoren, monolithischen OFW-Konvolvern und asynchronen OFW-Korrelator/programmierbaren signalangepaßten Filtern hingewiesen. In der erstgenannten Druckschrift werden jedoch lediglich in Hochvolt-Technik arbeitende Systeme auf Basis von Schottky-Dioden angegeben, die bei wesentlich höheren, Chip- und VLSI- inkompatiblen Spannungen arbeiten. Darüberhinaus stellen die bei dieser Implementation unvermeidbar auftretenden Sperrströme ein erhebliches Problem bei der Leistungsbegrenzung des Bauelementes dar. Aus der zweitgenannten Druckschrift sind Systeme bekannt, bei denen eine Phasenverschiebung der Oberflächenwelle über die spannungsgesteuerte Dicke einer Verarmungsschicht abgestimmt werden kann. Dabei handelt es sich jedoch um einen Volumeneffekt, bei dem die maximale Wechselwirkung zwischen Oberflächenwelle und beweglichen Ladungsträgern frequenzabhängig ist.

Der vorliegenden Erfindung liegt die Aufgabe zugrunde, sowohl mit kleinen Spannungen in der Größenordnung von höchstens einigen Volt betreibbare als auch mit einem von der Betriebsfrequenz unabhängigen Wechselwirkungsmechanismus arbeitende Bauelemente der vorstehend erläuterten Art anzugeben.

Diese Aufgabe wird bei einem mit akustischen Oberflächenwellen arbeitenden akusto-elektronischen Bauelement der eingangs genannten Art erfindungsgemäß durch die Maßnahmen nach dem kennzeichnenden Teil des Patentanspruch 1 gelöst.

Weiterbildungen der Erfindung sind Gegenstand von Unteransprüchen.

Die Erfindung wird nachfolgend anhand von Ausführungsbeispielen gemäß den Figuren der Zeichnung näher erläutert. Es zeigt:
- Figur 1: eine schematische perspektivische Darstellung eines erfindungsgemäßen Bauelementes in Form einer in ihrer Laufzeit elektrisch abstimmbaren Verzögerungsleitung;
- Figur 2: eine erste Ausführungsform eines in seiner elektrischen Leitfähigkeit durch Feldeffekt abstimmbaren Elektronenkanals;
- Figur 3: den Leitungsbandverlauf einer typischen GaAs-AlₓGa₁₋ₓAs-Heterostruktur;
- Figur 4: eine zweite Ausführungsform eines in seiner elektrischen Leitfähigkeit durch Feldeffekt abstimmbaren Elektronenkanals;
- Figur 5: einen prinzipiellen Aufbau einer Oszillatorschaltung unter Verwendung eines erfindungsgemäßen Bauelementes; und
- Figur 6: den prinzipiellen Aufbau eines elektrisch abstimmbaren Resonators unter Verwendung eines erfindungsgemäßen Bauelementes.

Generell gesprochen schafft die vorliegende Erfindung die Möglichkeit, über die Wechselwirkung von akustischen Oberflächenwellen mit einer in ihrer elektrischen Leitfähigkeit abstimmbaren Elektronenschicht in einer Halbleiterschichtstruktur voll integrierte spannungsgesteuerte Höchstfrequenzbauelemente zu realisieren, die im Bereich bis zu einigen GHz betreibbar sind. Dieser Frequenzbereich ist insbesondere im Zusammenhang mit Mobilfunk und Mobiltelefonverkehr technologisch sehr interessant. Grundlage der Erfindung ist dabei die Änderung der Laufzeit bzw. der Geschwindigkeit einer akustischen Oberflächenwelle durch Feldeffekt, was entweder direkt in einem piezoelektrischen Halbleitersystem oder in einem Hybridsystem aus einem Piezoelektrikum und einer - dann nicht notwendigerweise piozoelektrischen - Halbleiterschichtstruktur realisiert ist. Die Abstimmbarkeit beruht dabei im Gegensatz zu bereits bekannten Systemen auf einer direkten intrinsischen Wechselwirkung einer akustischen Oberflächenwelle mit einem quasi-zweidimensionalen Elektronensystem in einer Halbleiterstruktur.

Durch Feldeffekt kann die Ladungsträgerdichte in diesem quasi-zweidimensionalen Elektronensystem über eine Gate-Spannung gezielt eingestellt werden. Dadurch wird gleichzeitig die Flächenleitfähigkeit des quasi-zweidimensionalen Elektronensystems in weiten Grenzen variiert. Die Wechselwirkung der akustischen Oberflächenwelle mit dem quasi-zweidimensionalen Elektronensystem führt zu einer Dämpfung der akustischen Oberflächenwelle sowie zu einer Änderung der Schallgeschwindigkeit, welche beide direkt von der Leitfähigkeit des quasizweidimensionalen Elektronensystems abhängen.

Die zur Anwendung kommende Halbleiterstruktur kann voll kompatibel zu Strukturen gewählt werden, auf denen Höchstfrequenztransistoren für den in Frage kommenden Frequenzbereich hergestellt werden. Dadurch kann die gesamte Verstärkungs- und Steuerelektronik ohne zusätzlichen Aufwand auf einem einzigen Chip voll integriert werden.

Erfindungsgemäße Strukturen sind weiterhin voll kompatibel zu der heute weit entwickelten Technologie der Hochfrequenz-Signalverarbeitung mit Hilfe von mit akustischen Oberflächenwellen arbeitenden Bauelementen. Durch Integration von mit akustischen Oberflächenwellen arbeitenden Bauelementen in zur Hochfrequenzelektronik kompatiblen Halbleitersystemen und Ausnutzung eines intrinsischen Wechselwirkungsmechanismus können daher erfindungsgemäß sehr komplexe Funktionen auf einem Chip in Planartechnologie realisiert werden.

Bei erfindungsgemäßen Bauelementen sind neben der Chip- und VLSI-Kompatibilität der verwendeten Arbeitsspannungen die aufgrund des komplett unterschiedlichen Grundprinzips auftretenden Sperrströme vernachlässigbar und das Bauelement ist somit extrem leistungsarm steuerbar. Darüber hinaus ist die maximale Wechselwirkung zwischen akustischen Oberflächenwellen und quasi-zweidimensionalen Elektronensystemen in weiten Grenzen und im Gegensatz zu der bei oben beschriebenen auf Volumeneffekten beruhenden Elementen nicht von der Frequenz der Oberflächenwelle abhängig, so daß auch ein gleichzeitiger Betrieb erfindungsgemäßer Bauelemente bei gleicher funktionaler Abstimmbarkeit auf verschiedenen Frequenzen denkbar wird.

Gemäß der schematischen perspektivischen Darstellung eines erfindungsgemäßen Bauelementes in Form einer elektrisch abstimmbaren mit akustischen Oberflächenwellen arbeitenden Verzögerungsleitung sind auf einem piezoelektrischen Substrat 1 zwei Interdigitalwandler 2 und 3 vorgesehen, bei denen es sich beispielsweise um einen Eingangs- und einen Ausgangsinterdigitalwandler der Verzögerungsleitung handelt. In der Laufstrecke einer akustischen Oberflächenwelle zwischen den beiden Interdigitalwandlern 2 und 3 ist ein quasizweidimensionales Elektronensystem 4 mit einem ohmschen Kontakt 5 für dieses System sowie einem Kontakt 6 für eine nicht eigens dargestellte Feldelektrode vorgesehen.

Wie bereits oben ausgeführt, kann die Laufzeit bzw. die Geschwindigkeit der akustischen Oberflächenwelle in der Laufstrecke zwischen den Interdigitalwandlern 2 und 3 durch Feldeffekt mittels einer an den Kontakt 6 und die - nicht eigens dargestellte - Feldelektrode gesteuert werden. Daraus ergibt sich eine Vielzahl von Anwendungsmöglichkeiten, die auf der Änderung der Geschwindigkeit der akustischen Oberflächenwelle durch Feldeffekt beruhen. Es kann sich dabei beispielsweise um die bereits angesprochene Verzögerungsleitung, um spannungsgesteuerte Oszillatoren, Resonatoren, Spannungssensoren oder Sensoren für andere Größen als elektrische Spannungen handeln.

Für die praktische Realisierung von erfindungsgemäßen Bauelementen ergibt sich eine Vielzahl von Möglichkeiten.

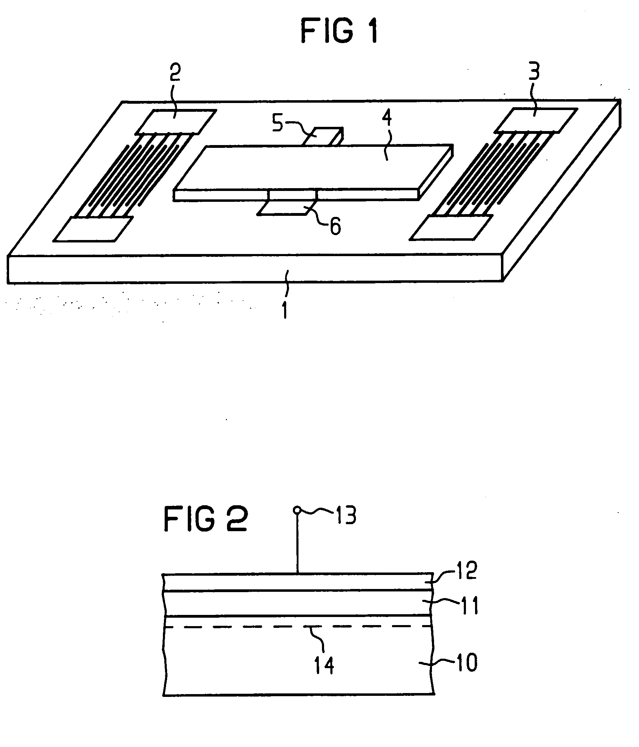

Gemäß einer Weiterbildung der Erfindung können das piezoelektrische Substrat 1 und der quasi-zweidimensionale Elektronenkanal 4 nach Figur 1 in einer einzigen piezoelektrischen Halbleiterstruktur vereinigt sein. Als piezoelektrische Halbleitermaterialien kommen dabei die an sich bekannten binären, ternären und quaternären III-V- bzw. II-VI-Verbindungen, Heterostrukturen oder Überstrukturen aus diesen in Frage. Als spezielle Beispiele für derartige Halbleitermaterialien sei auf GaAs, GaAsP, Indiumantimonid oder Indiumgalliumarsenid hingewiesen.

In weiterer Ausgestaltung der Erfindung können das piezoelektrische Substrat 1 und der quasi-zweidimensionale Elektronenkanal 4 nach Figur 1 als Hybidstruktur aus einem piezoelektrischen Material und einer Halbleiterstruktur ausgebildet sein. Dabei kann entweder die den Elektronenkanal enthaltende Halbleiterstruktur auf einem piezoelektrischen Substrat oder ein piezoelektrisches Material auf eine den Elektronenkanal enthaltende Halbleiterstruktur aufgebracht sein. Als Material für das piezoelektrische Substrat kommen dabei alle in der Technik von mit akustischen Oberflächenwellen arbeitenden Bauelementen zur Anwendung kommenden Materialien, wie beispielsweise Lithiumtantalat, Lithiumniobat, Quarz oder Zinkoxid in Betracht. Als Materialien für die den Elektronenkanal enthaltende Halbleiterstruktur kommen alle in der Halbleitertechnik verwendeten Materialien, wie beispielsweise die bereits erwähnten Verbindungshalbleiter, Silizium, Germanium, halbleitende Polymere oder Siliziumcarbid in Betracht.

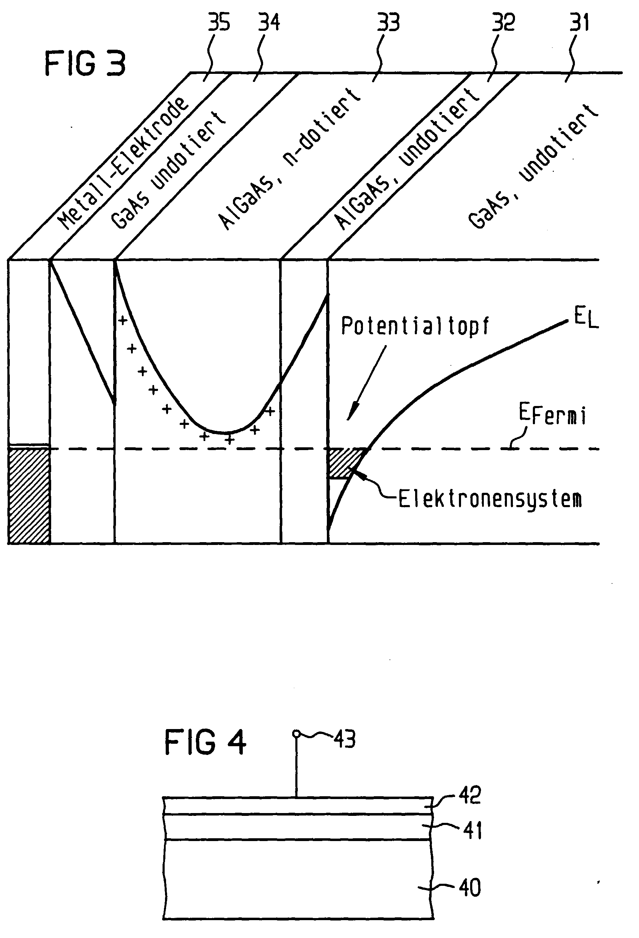

Zwei mögliche Ausführungsformen für ein quasizweidimensionales Elektronensystem sind in den Figuren 2 und 3 dargestellt.

Figur 2 zeigt eine Ausführungsform einer Halbleiterheterostruktur. Dabei ist auf einem halbleitendem Substrat 10 beispielsweise aus GaAs eine dotierte Halbleiterschicht 11 beispielsweise aus dem ternären AlGaAs aufgebracht, wodurch eine halbleitende Heterostruktur gebildet wird. Auf die Schicht 11 ist eine Feldelektrode 12 mit einem elektrischen Anschluß 13 aufgebracht. Dabei ist im Substrat 10 ein quasizweidimensionales Elektronensystem 14 ausgebildet, das in seiner Leitfähigkeit über eine Spannung am Anschluß 13 der Feldelektrode steuerbar ist.

Durch die vorgenannte Ausbildung der Halbleiterheterostruktur ergibt sich der für eine Heterostruktur typische Verlauf von Valenz- und Leitungsband, in dem sich ein Potentialtopf für das niedrigdimensionale Elektronensystem ausbildet.

Figur 3 zeigt den Leitungsbandverlauf einer typischen GaAs-AlₓGaₓ₋₁As-Heterostruktur mit einer Schichtfolge in der Figur von rechts nach links gesehen: eine undotierte GaAs-Schicht 31, eine undotierte AlGaAs-Schicht 32, eine n-dotierte AlGaAs-Schicht 33, eine undotierte GaAs-Schicht 34 sowie eine Metall-Elektrode 35. Die sich dabei ergebende Leitungsbandkante bzw. der Leitungsbandverlauf ist mit E_{L} bezeichnet. Das Fermi-Niveau ist gestrichelt dargestellt und mit E_{fermi} bezeichnet.

Auf der Seite der undotierten AlGaAs-Schicht 32 entsteht in der undotierten GaAs-Schicht 31 ein Potentialtopf, in dem sich erfindungsgemäß das quasi-zweidimensionale Elektronensystem ausbildet.

Bei der Ausführungsform nach Figur 4 ist ein durch Feldeffekt steuerbarer Elektronenkanal bzw. ein quasi-zweidimensionales Elektronensystem in einer MISFET-Struktur ausgebildet. Speziell wird dabei die MIS-Diode durch eine Halbleiterschicht 40, eine Isolatorschicht 41 und eine darauf befindliche Feldelektrode 42 mit einem elektrischen Anschluß 43 gebildet. Bei der Halbleiterschicht 40 kann es sich beispielsweise um Silizium und bei der Isolatorschicht 41 um Siliziumdioxid handeln.

Im Rahmen der Erfindung ist ein quasi-zweidimensionales Elektronensystem bzw. ein durch Feldeffekt in seiner elektrischen Leitfähigkeit steuerbarer Elektronenkanal nicht nur durch Anordnungen realisierbar, wie sie in den Figuren 2 bis 4 dargestellt sind. Beispielsweise ist auch eine Realisierung durch eine an sich bekannte - in den Zeichnungen nicht eigens dargestellte - Polymer-Feldeffektstruktur möglich.

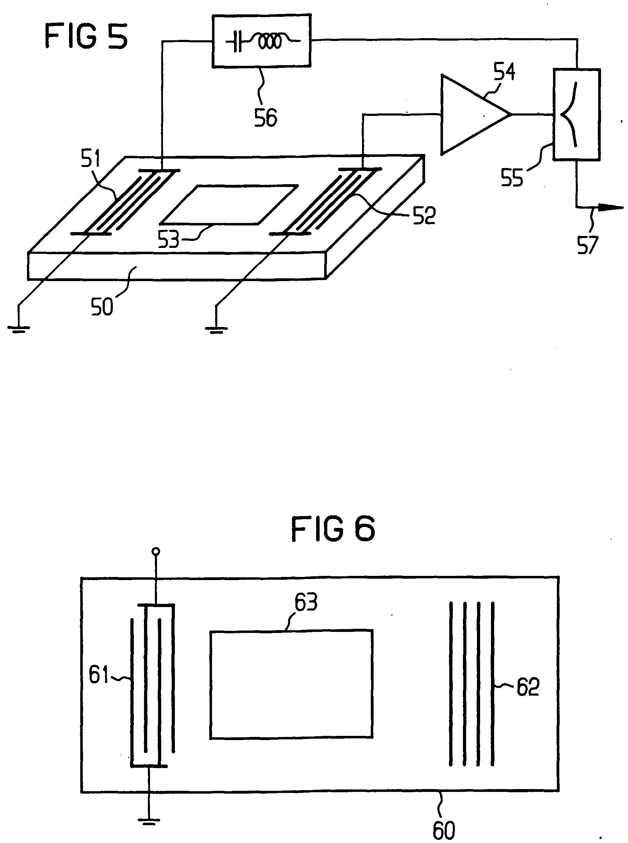

Figur 5 zeigt als Ausführungsbeispiel einer Anwendung eines erfindungsgemäßen Bauelementes in schematischer Darstellung einen spannungsgesteuerten Oszillator. Das erfindungsgemäße Bauelement wird dabei entsprechend der Ausführungsform nach Figur 1 durch ein piezoelektrisches Substrat 50 mit zwei darauf befindlichen Interdigitalwandlern 51 und 52 sowie einem in der Laufstrecke einer akustischen Oberflächenwelle zwischen den Interdigitalwandlern 51 und 52 angeordneten durch Feldeffekt über die angelegte Gate-Spannung steuerbaren Elektronenkanal 53 gebildet. Ein Rückkopplungskreis zwischen den beiden Interdigitalwandlern 51 und 52 wird durch einen Hochfrequenzverstärker 54, einen Leistungsverteiler 55 sowie ein Bandpaßfilter 56 gebildet. Das Oszillatorausgangssignal ist an einem Ausgang 57 des Leistungsteilers 55 abnehmbar.

Figur 6 zeigt eine Ausführungsform eines mit akustischen Oberflächenwellen arbeitenden Resonators unter Verwendung eines erfindungsgemäßen Bauelementes. Dabei sind auf einem piezoelektrischen Substrat 60 ein Interdigitalwandler 61, ein Reflektor 62 sowie in der Laufstrecke einer akustischen Oberflächenwelle zwischen dem Interdigitalwandler 61 und dem Reflektor 62 ein in seiner Leitfähigkeit durch Feldeffekt steuerbarer Elektronenkanal 63 vorgesehen. Es ist bei einem derartigen Resonator auch möglich, den in seiner elektrischen Leitfähigkeit steuerbaren Elektronenkanal 63 mindestens zum Teil auch auf dem Interdigitalwandler 61 oder dem Reflektor 62 zuzuordnen, wodurch die elektro-akustischen Wechselwirkungen in Form von sowohl elektrischen als auch akustischen Reflexionen entsprechend beeinflußbar sind.

Ein erfindungsgemäßes Bauelement ist weiterhin als Spannungssensor verwendbar, wobei die Größe einer an den in seiner elektrischen Leitfähigkeit durch Feldeffekt steuerbaren Elektronenkanal angelegten Spannung über die Laufzeit einer akustischen Oberflächenwelle meßbar ist.

Es sind darüberhinaus Detektoren für andere als elektrische Spannungen realisierbar, wozu beispielsweise auf an sich bekannte, jedoch lediglich mit akustischen Oberflächenwellen arbeitende Gassensoren hingewiesen wird, die mit erfindungsgemäßen Elektronensystemen erweiterbar sind.

Es sei schließlich auch noch auf besonders günstige Herstellungsmöglichkeiten mittels der an sich bekannten Lift-Off-Technik hingewiesen, wie sie beispielsweise in "1995 Ultrasonics Symposium", 401-404 beschrieben ist.

## Patentansprüche

1. Mit akustischen Oberflächenwellen arbeitendes akustoelektronisches Bauelement mit einem piezoelektrischen Substrat (beispielsweise 1), in dem eine akustische Oberflächenwelle geführt wird, und mit einem mit der akustischen Oberflächenwelle in Wechselwirkung tretenden Elektronensystem,
**dadurch gekennzeichnet,**
daß das Elektronensystem als auf dem piezoelektrischen Substrat (beispielsweise 1) in der Laufstrecke der akustischen Oberflächenwelle angeordnetes in seiner elektrischen Leitfähigkeit durch Feldeffekt abstimmbarer Elektronenkanal (beispielsweise 4, 5, 6) ausgebildet ist.

2. Bauelement nach Anspruch 1,
**dadurch gekennzeichnet,**
daß das piezoelektrische Substrat und der Elektronenkanal in einer piezoelektrischen Halbleiterstruktur vereinigt sind.

3. Bauelement nach Anspruch 2,
**dadurch gekennzeichnet,**
daß das Material der piezoelektrischen Halbleiterstruktur eine binäre, ternäre oder quaternäre III-V- oder II-VI-Verbindung, eine Heterostruktur oder eine Übergitterstruktur aus diesen ist.

4. Bauelement nach Anspruch 2 und 3,
**dadurch gekennzeichnet,**
daß das Material der piezoelektrischen Halbleiterstruktur GaAs ist.

5. Bauelement nach Anspruch 2 und 3,
**dadurch gekennzeichnet,**
daß das Material der piezoelektrischen Halbleiterstruktur GaAsP ist.

6. Bauelement nach Anspruch 2 und 3,
**dadurch gekennzeichnet,**
daß das Material der piezoelektrischen Halbleiterstruktur Indiumantimonid ist.

7. Bauelement nach Anspruch 2 und 3,
**dadurch gekennzeichnet,**
daß das Material der piezoelektrischen Halbleiterstruktur Indiumgalliumarsenid ist.

8. Bauelement nach Anspruch 1,
**dadurch gekennzeichnet,**
daß das piezoelektrische Substrat und der Elektronenkanal als Hybidstruktur aus einem piezoelektrischen Material und einer Halbleiterstruktur ausgebildet ist.

9. Bauelement nach Anspruch 8,
**dadurch gekennzeichnet,**
daß die den Elektronenkanal enthaltende Halbleiterstruktur (4, 5, 6) auf einem piezoelektrischen Substrat (1) ausgebildet ist.

10. Bauelement nach Anspruch 8 und 9,
**dadurch gekennzeichnet,**
daß das Material für das piezoelektrische Substrat (1) aus der Gruppe Lithiumtantalat, Lithiumniobat, Quarz, Zinkoxid ausgewählt ist.

11. Bauelement nach einem der Ansprüche 8 bis 10,
**dadurch gekennzeichnet,**
daß das Material für die den Elektronenkanal enthaltende Halbleiterstruktur (4, 5, 6) aus der Gruppe der Verbindungshalbleiter, Silizium, Germanium, halbleitende Polymere, Siliziumkarbid ausgewählt ist.

12. Bauelement nach einem der Ansprüche 8, 10 oder 11,
**dadurch gekennzeichnet,**
daß auf eine den Elektronenkanal enthaltender Halbleiterstruktur ein piezoelektrisches Material aufgebracht ist.

13. Bauelement nach einem der Ansprüche 1 bis 12,
**dadurch gekennzeichnet,**
daß der durch Feldeffekt in seiner elektrischen Leitfähigkeit steuerbare Elektronenkanal (14) durch eine Halbleiterheterostruktur (10, 11) gebildet ist.

14. Bauelement nach Anspruch 13,
**dadurch gekennzeichnet,**
daß die Halbleiterheterostruktur durch Halbleiterschichten (10, 11) mit unterschiedlichem Bandabstand zwischen Valenzband und Leitungsband gebildet ist.

15. Bauelement nach Anspruch 14,
**dadurch gekennzeichnet,**
daß die Halbleiterheterostruktur durch eine Galimarsenidschicht (10) und eine auf diese aufgewachsene mit Aluminium dotierte Galiumarsenitschicht (11) gebildet ist.

16. Bauelement nach einem der Ansprüche 1 bis 12,
**dadurch gekennzeichnet,**
daß der in seiner elektrischen Leitfähigkeit durch Feldeffekt steuerbare Elektronenkanal in einer MISFET-Struktur ausgebildet ist.

17. Bauelement nach Anspruch 16
**dadurch gekennzeichnet,**
daß die MISFET-Struktur durch eine MIS-Diode (40, 41, 42) gebildet ist.

18. Mit akustischen Oberflächenwellen arbeitende, abstimmbare Verzögerungsleitung unter Verwendung eines Bauelementes nach einem der Ansprüche 1 bis 16 mit einem Eingangs- und einem Ausgangsinterdigitalwandler (2, 3) auf einem piezoelektrischen Substrat (1) und einem zwischen den Interdigitalwandlern (2, 3) vorgesehenen durch Feldeffekt in seiner elektrischen Leitfähigkeit abstimmbaren Elektronenkanal (4, 5, 6).

19. Verwendung einer abstimmbaren Verzögerungsleitung nach Anspruch 18 als Spannungssensor.

20. Verwendung einer Verzögerungsleitung nach Anspruch 18 als frequenzbestimmendes Element in einem spannungsgesteuerten Oszillator.

21. Mit akustischen Oberflächenwellen arbeitender Resonator unter Verwendung eines Bauelementes nach einem der Ansprüche 1 bis 17 mit mindestens einem Interdigitalwandler (61) und mindestens einem Reflektor (62) sowie mit einem in der Laufstrecke einer akustischen Oberflächenwelle zwischen Interdigitalwandler (61) und Reflektor (62) angeordneten in seiner elektrischen Leitfähigkeit durch Feldeffekt abstimmbaren Elektronenkanal (63).

22. Mit akustischen Oberflächenwellen arbeitender Resonator unter Verwendung eines Bauelementes nach einem der Ansprüche 1 bis 17 mit mindestens einem Interdigitalwandler (61) und einem Reflektor (62), bei dem mindestens eines der Elemente Interdigitalwandler (41) oder Reflektor (62) mindestens teilweise durch ein in seiner elektrischen Leitfähigkeit abstimmbares Elektronensystem (63) gebildet ist.

23. Halbleitersensor unter Verwendung eines Bauelementes nach einem der Ansprüche 1 bis 17,
**dadurch gekennzeichnet,**
daß der in seiner elektrischen Leitfähigkeit durch Feldeffekt abstimmbare Elektronenkanal und/oder das die akustische Oberflächenwelle führende Substrat als auf eine zu detektierende Größe ansprechende Struktur ausgenutzt wird.
